Europäisches Patentamt

European Patent Office

Office européen des brevets

(19)

(11) EP 1 152 066 A1

(12) EUROPEAN PATENT APPLICATION

(43) Date of publication:
07.11.2001 Bulletin 2001/45

(51) Int Cl.$^7$: C23C 16/30

(21) Application number: 01304074.6

(22) Date of filing: 04.05.2001

(84) Designated Contracting States:
AT BE CH CY DE DK ES FI FR GB GR IE IT LI LU
MC NL PT SE TR
Designated Extension States:
AL LT LV MK RO SI

(30) Priority: 05.05.2000 US 566096

(71) Applicants:
• Ingersoll-Rand Company
Woodcliff Lake, New Jersey 07677-7700 (US)
• THE UNIVERSITY OF CINCINNATI
Cincinnati, OH 45221-0012 (US)

(72) Inventors:
• Hein, Gerald F.
Cincinnati, Ohio 45230 (US)
• Lin, Chih-Tao
Yung-Ho, Tapei (TW)
• Li, Feng
Cincinnati, Ohio 45223 (US)
• Mantei, Thomas D.
Cincinnati, Ohio 45232 (US)

(74) Representative: Feakins, Graham Allan et al
RAWORTH, MOSS & COOK
RAWORTH HOUSE
36 Sydenham Road
Croydon, Surrey CRO 2EF (GB)

(54) Coloured metal nitride films and process of manufacturing

(57) New titanium and zirconium "nitride" films containing carbon, substantial oxygen and minor amounts of carbon and other impurities are prepared in commercial reactors with predetermined opacity, colour and electrical conductivity.

The coloured films can contain atomic oxygen concentrations of 5-60%. The opaque brass and gold films have atomic oxygen concentrations of 5 - 45% atomic oxygen and more preferably 7 - 30% for both the titanium and zirconium nitrides. The preferred atomic oxygen concentrations of the essentially dielectric transparent coloured films can have atomic oxygen concentrations of up to 60%. The reactors can be commercial but preferably include electrical leads which can be used to contact the forming films from time to time during start-up and quality assurance testing. To obtain the conductive opaque films, there will be higher power inputs and higher additive gas to carrier gas flow ratios. To obtain the dielectric films, lower power inputs and lower additive gas to carrier flow ratios are utilised.

Fig. 1

EP 1 152 066 A1

**EP 1 152 066 A1**

**Description**

This invention relates to the deposition of highly impure "metal nitride" films on a substrate and more particularly to the deposition of titanium and zirconium nitride films containing carbon, substantial amounts of oxygen and minor amounts of other impurities on, preferably, metal substrates under conditions which provide coatings having the appearance of brass or gold with selectable properties. The films have excellent adhesion, where desired, and good corrosion resistance.

Opaque titanium nitride (TiN) coatings are utilised in coating drill bits and cutting tools to provide highly effective wear resistance. These tools are recognizable by their gold colour. Zirconium nitride (ZrN) coatings are also utilised to provide the desired brass colour to architectural hardware and plumbing hardware such as door handles, levers, knobs, locks, taps and shower heads. Transparent coatings of similar materials can have high electrical resistivity and be equally useful in architectural glass and ophthalmic lenses when stacked with $SiO_2$ layers.

Perfect stoichiometry is difficult to find in TiN and ZrN films, partially because the processes required to deposit such films require rather severe reaction conditions. Zirconium nitride films, for example, have been prepared by sputtering, reactive sputtering, cathodic arc deposition, ion plating, electron beam evaporation, laser reduction of ZnO in an ammonia atmosphere, thermal chemical vacuum deposition (CVD) using zirconium dialkylamides as precursors, and plasma assisted chemical vapour deposition.

While the work leading to the development of the present processes and compositions and of others mentioned below is plentiful, it is evident that the processes of the prior art and equipment are not sufficiently developed to provide predictability in the search for new products and processes. Thus, chemical compositions of pure titanium nitride ranges from $TiN_{0.42}$ to $TiN_{1.6}$ and pure zirconium nitride from $Zr_3N_2$ to $Zr_3N_8$ according to P. Schwarzkopf et al, Refractory Hard Metals, (McMillan, N.Y., N.Y. 1953); P. Ehrlich, *Z. Anorg. Chem.,* 259, 1 (1949), and A. Brager, *Acta Physicochim*, U.S.S.R., 10, 887 (1939). The processes for preparing the varying compositions can significantly affect the thermodynamic, mechanical, magnetic, superconducting and optical properties of the films. For example, a "ZrN" film is electrically conducting with an opaque film having a brass metallic color but a $Zr_3N_4$ film is an electrically insulating yellow transparent film.

Gold or brass coloured electrically conductive coatings are not the norm for the nitrides of the transition metals. Thus, for example, the polished nitrides of niobium and tantalum are gray; the nitride of chromium is a gray brown, the nitride of vanadium is a combination of gray red and brown. Hafnium nitride is a golden green. Such coatings are not even the norm for products of the various chemical vapour deposition procedures leading to the preparation of the various nitrides.

The following references are also relevant to the present process. Hsin-Tien Chiu et al (Material Letters, 16 194-199 (1993)) report the typical deposition of zirconium carbonitride thin films on silicon and glass substrates at temperatures of 392°F (200°C) to 1202°F (650°C) via low pressure CVD using a zirconium tetra diethylamine complex as a precursor. The higher process temperatures can melt some uncooled glass and plastic substrates. H. Wendel et al, App. Phys. A**54**, 389-392 (1992) describe the use of PECVD to deposit electrically nonconducting, brown to bluish green to dark green colored films onto glass, silicon, aluminum and steel using radio frequency (rf) waves to form the plasma and tetrakis-(diethyl amino) zirconium as the precursor. Hydrogen, ammonia and nitrogen were utilized as carriers and additives.

A. Webber et al., App. Phys. Lett. 67 (20), Nov. 1995, describes PECVD processes using substrate temperatures of from 212°F to 842°F (100 - 450°C) to produce gold coloured titanium nitride films from tetra-isopropoxide titanium utilizing electron cyclotron resonance (ECR PECVD). The growth rates were less than 2 nm/min; the resulting films contained 2 atomic percent or less oxygen and film resistivity was low, i.e., 5000 μΩcm.

A. Webber et al, Microelectronic Engineering 33 (1997) 272-288 utilised hydrogen, nitrogen or ammonium carriers combined with the precursor tetra-isopropoxide titanium with PECVD to form "high quality" titanium nitride films. The films contained up to 2 atomic percent oxygen and 4 percent carbon, the resistivity was about 200 to about 450 μΩcm and varied with the deposition rate. In each instance Webber et al were seeking to make titanium nitride with no oxygen, carbon, etc.

A. Webber et al, J. Electrochem. Soc. Vol. 144, 3/97 teach a low temperature process for making barrier materials for integrated circuit devices. Thus, titanium nitride films were formed on plastics by using ECR PCVD where tetra isopropoxide titanium is introduced into the downstream region of a nitrogen ECR plasma. A rough titanium nitride was formed which provided good adhesion for a later electro-deposited copper layer.

L.M. Atagi, et al, Mat. Rev. Soc. Symp. Proc., Vol. 410, 1996 teach a process using higher frequency microwave driven PECVD instead of radio frequencies and using a tetrakis diethylamido zirconium precursor and mixtures of argon and ammonia to obtain growth rates of 60-120 nm/min. They report obtaining high quality transparent yellow films which were produced in a microwave plasma on quartz and silicon substrates and provided films having "little or no oxygen" and very low electrical conductivity.

The above comments about the references are very brief summaries of the references and of the data in a greater number of references and they are not intended to be complete. Although articles and books have been written about various CVD processes, the predictive use of the known process variables to achieve desired materials is still uncertain and rudimentary. For example, most research is normally directed toward the production of pure compounds, films, etc., because much of the continuing research and development is directed towards films for use by the semiconductor industry. Ordinarily, a pure film is sought for characterisation. Once characterised, the compounds and films are "doped" by adding small amounts of impurities to obtain a spectrum of the doped materials' characteristics, e.g., specific physical and electronic characteristics.

The decorative architectural hardware researchers must utilise the same approaches. However, it was very unexpected to find that opaque films with desired colour characteristics and conductivity can be very impure with substantial oxygen. It is even more surprising to find that such films can be highly conductive, and slight modifications of the manufacturing process can also provide electrically insulating films useful in optics for glasses, etc. because of the differences in atomic structures between the two types of films.

The titanium and zirconium nitride films of this invention can contain carbon and large amounts of oxygen impurities. Some of these films are highly resistive and are often transparent and yellow in colour. The remaining preferred films low resistance and range from brass to gold colours. The films are manufacturable in commercial type reactors at relatively low substrate deposition temperatures, e.g., respectively, below 482°F (250°C) and 572°F (300°C). Additionally, the films have very strong adhesion to metals, glass and some plastics and excellent hardness.

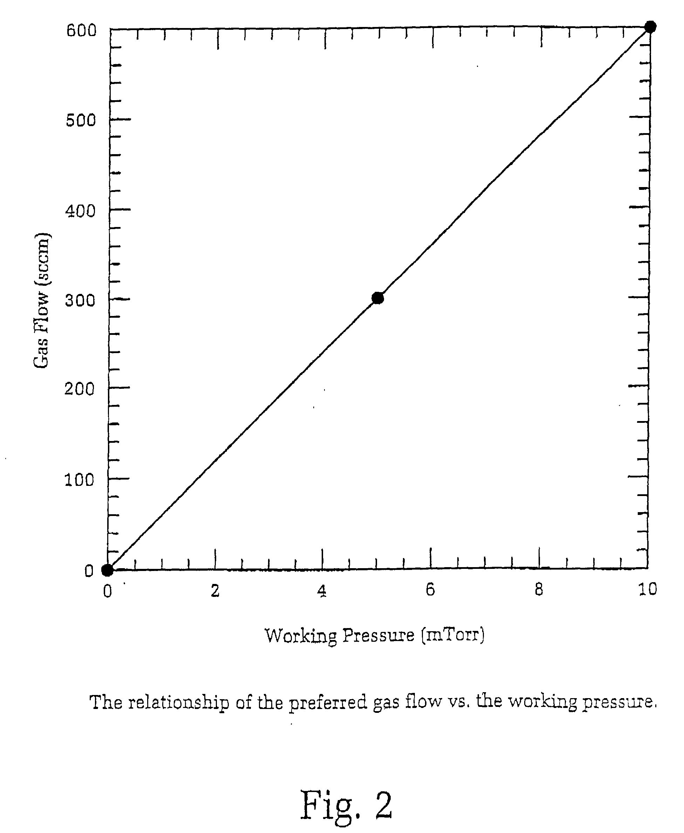

Process conditions which provide the preferred highly conductive films include a linear relationship between the gas flow vs. the working pressure at a constant pump speed (See Fig.2) and higher power input and higher $N_2$ and/or $NH_3$ additive gas flows to increase the metal nitride concentration, and lower power inputs and gas flows to obtain higher metal oxide concentrations and high electrical resistivity.

For a better understanding of the invention and to show how the same may be carried into effect, reference will now be made, by way of example, to the accompanying drawings, in which:-

Figure 1 is a schematic drawing of a preferred reactor; and
Figure 2 is a graph of preferred operating gas flow and working pressure relationships.

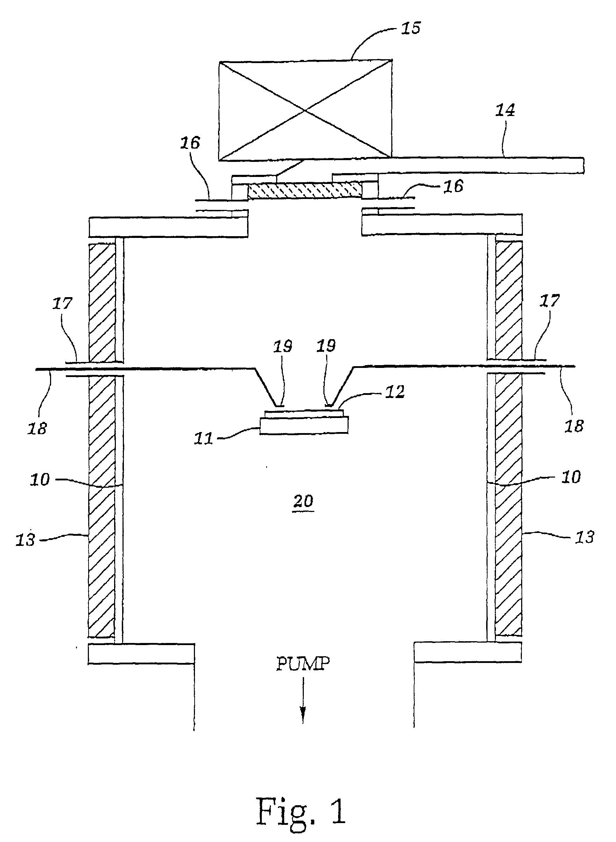

A reactor was utilised in the development of the present products and processes which is somewhat similar to the Plasma Quest line of reactors. Suitable reactors are shown in US-A-4 483 737, US-A-5 196 670 and US-A-5 869 802. A schematic of the preferred type reactor is provided by Figure 1 where the reactor 10 surrounds a holder 11 on which a substrate 12 is positioned. Magnets 13 with alternately reversed polarity are positioned vertically around the circumference of the reactor. To produce the desired films on the substrate 12, an exemplary 2.45 GHz wave is introduced into the reactor 10 through wave guide 14. The 2.45 GHz energy is oriented along the DC field of the Nd. Fe.B magnet 15 during the introduction of carrier and additive through inlet piping 16. Precursor gases enter through piping 17. An exhaust pump (not shown) removes the reacted gases. Ohm meter leads 18 are used to periodically check the resistivity of the forming films. The leads 18 position contacts 19 in a non-ion particle blocking position adjacent the substrate 12 when checks are not being made. The contacts 19 are covered by a cover (not shown) which is displaced by the movement of the contacts 19 when the leads are moved into contact with the forming film.

The low aspect ratio system of Figure 1 utilises a single high field permanent magnet 15, with the ECR zone formed within the processing chamber. Preferably, a set of multiple permanent magnets 13 ranging from 0.01 tesla to 0.2 tesla surrounds the process chamber 20 to improve plasma uniformity.

To generate the ECR plasma, the microwave power is passed through a wave guide and injected axially into the process chamber through a dielectric window in the presence of the axial magnetic field to generate the plasma via the resulting electron cyclotron resonance. The wave absorption is increased by the application of a moderate, steady magnetic field, preferably direct current, with a field strength related to the required input frequency of $qB/m = w$, where B is the field strength at the region of the plasma generation, q and m are the electronic charge and mass and w is the input power frequency, e.g., field strength of from about 0.0035 tesla to about 0.35 tesla, more preferably from about 0.018 tesla to about 0.18 tesla and most preferably from 0.03 tesla to 0.09 tesla.

The electron cyclotron resonance (ECR) plasmas will utilise frequencies of about 0.1 GHz to about 10 GHz, more preferably frequencies of about 0.5 GHz to about 5 GHz, and most preferably frequencies of about 0.9 GHz to about 2.5 GHz. The electron cyclotron resonance (ECR) plasmas utilized in the process of this invention will have an ion density of about $10^9$ cm$^{-3}$ to $10^{13}$ cm$^{-3}$, more preferably from about $10^{10}$ cm$^{-3}$ to $10^{12}$ cm$^{-3}$ and most preferably from about $10^{11}$ cm$^{-3}$ to $5x10^{11}$ cm$^{-3}$. The ion current density can range from 0.05 mA/cm$^2$ to 50 mA/cm$^2$, more preferably, 0.2 mA/cm$^2$ to 20 mA/cm$^2$ and most preferably 1.0 mA/cm$^2$ to 10 mA/cm$^2$. These various densities will be formed at pressures of from about $10^{-4}$ Torr to 1.0 Torr, more preferably at pressures of from about $10^{-3}$ Torr to 0.5 Torr and most preferably at pressures of from about $3x10^{-3}$ Torr to 0.3 Torr.

To obtain optimum metal nitride deposition rates on the substrate(s), a predetermined and substantially uniform reactant gas flow around the substrate(s) is required.

Figure 2 graphs the relationship of the effective pumping speed, gas flow rate, and chamber pressure for the reactor which can be calculated as:

$$Q_{in} = PS_{eff}$$

where $Q_{in}$ is the gas flow rate, $S_{eff}$ is the effective pumping speed, and P is the chamber pressure. Therefore, if the effective pumping speed ($S_{eff}$) and chamber pressure (P) are known, then the gas flow rate ($Q_{in}$) can be calculated. Under normal process conditions, $S_{eff}$ can be considered as a constant, which leads to a linear relationship of $Q_{in}$ and P as shown.

More specifically, the preferred partial pressures of the involved gases with an effective pumping speed of 769 liters/sec are: (1) For Zr-containing coatings, the partial pressure of helium plus precursor, i.e., zirconium t-butoxide, is preferably from 0.25 mTorr to 0.75 mTorr with the partial pressure of $NH_3$ fixed at 3.50 mTorr. (2) For coatings containing TiN, the partial pressure of helium (or argon) plus titanium isopropoxide is fixed at 1.25 mTorr with the partial pressure of $NH_3$ ranging preferably from 1.25 mTorr to 3.75 mTorr.

The opaque and non-opaque films can contain from about 5 to 60 atomic percent oxygen. The opaque, colored titanium and zirconium films can contain about 5 to 35 atomic percent oxygen and more preferably 7 atomic percent oxygen. Preferably, the conductive, opaque films contain 15-30 atomic percent oxygen.

Table 1 sets out the atomic percentages and stoichiometry of five representative samples of coloured highly conductive zirconium nitride films.

TABLE 1

| Sample Number | O | Zr | N | C | Fe | Si | Stoichiometry |
|---|---|---|---|---|---|---|---|
| Z-1 | 44 | 37 | 12 | 7.8 | 0.0 | 0.0 | $ZrO_{.69}N_{.19}C_{.12}$ |
| Z-2 | 52 | 36 | 7.0 | 4.4 | 0.0 | 0.0 | $ZrO_{.82}N_{.11}C_{.07}$ |
| Z-3 | 33 | 39 | 19 | 9.0 | 0.0 | 0.1 | $ZrO_{.54}N_{.31}C_{.15}$ |
| Z-4 | 24 | 40 | 23 | 13 | 0.0 | 0.5 | $ZrO_{.40}N_{.38}C_{.22}$ |
| Z-5 | 30 | 39 | 20 | 11 | 0.0 | 0.1 | $ZrO_{.49}N_{.33}C_{.18}$ |

Table 2 shows the experimental conditions using zirconium t-butoxide/$NH_3$/He for the films of Table 1 with usual properties approximating those of the brass standard of the color analysis discussed below.

TABLE 2

| Sample Number | Power (W) | He Partial Pressure (mTorr) | NH₃ Partial Pressure (mTorr) | Dep. Time (min) |
|---|---|---|---|---|
| Z-1 | 1500 | 0.25 | 3.50 | 20 |
| Z-2 | 1500 | 0.75 | 3.50 | 15 |
| Z-3 | 2000 | 0.50 | 3.50 | 15 |
| Z-4 | 2500 | 0.25 | 3.50 | 20 |
| Z-5 | 2500 | 0.75 | 3.50 | 15 |

Table 3 sets out the atomic percentages and stoichiometry of 10 representative samples of the titanium nitrides of this invention.

TABLE 3

| Sample # | O | Ti | N | C | Stoichiometry |
|---|---|---|---|---|---|
| T-1 | 24 | 42 | 28 | 4.1 | $TiO_{.43}N_{.50}C_{.07}$ |
| T-2 | 27 | 41 | 27 | 4.1 | $TiO_{.47}N_{.47}C_{.06}$ |
| T-3 | 21 | 41 | 30 | 5.3 | $TiO_{.37}N_{.53}C_{.10}$ |
| T-4 | 27 | 42 | 26 | 3.4 | $TiO_{.48}N_{.46}C_{.06}$ |
| T-5 | 23 | 40 | 29 | 6.1 | $TiO_{.40}N_{.50}C_{.10}$ |

TABLE 3   (continued)

| Sample # | O | Ti | N | C | Stoichiometry |
|---|---|---|---|---|---|
| T-6 | 29 | 43 | 24 | 3.7 | $TiO_{.51}N_{.42}C_{.07}$ |
| T-7 | 27 | 43 | 27 | 2.8 | $TiO_{.48}N_{.48}C_{.04}$ |
| T-8 | 25 | 41 | 27 | 4.0 | $TiO_{.45}N_{.48}C_{.07}$ |
| T-9 | 30 | 40 | 24 | 3.1 | $TiO_{.53}N_{.42}C_{.05}$ |
| T-10 | 29 | 40 | 25 | 4.7 | $TiO_{.49}N_{.43}C_{.08}$ |

In addition to the elements listed in Table 3, trace amounts of other elements, such as iron and silicon, were measured. It is believed that the iron and silicon signals were coming from the substrate due to the thinness of the films being measured.

Of the five zirconium nitride coating samples shown, Z-1 and Z-2 have a purple appearance due to thin film optical interference. The remaining samples are a metallic brass colour. All the 10 titanium nitride samples tested have a metallic gold colour.

The colour analysis of various zirconium and titanium coating compounds was prepared using a Minolta CM-36000 spectrophotometer and a CIE L*a*b* technique. The samples had 30% oxygen and high conductivity except as noted. The L*a*b* values can be interpreted as the brightness, redness and yellowness of the samples.

The following tables 4 and 5 provide the results of the colour analysis using the CIE L*a*b* of, respectively, the impure zirconium nitrides and the titanium nitrides.

TABLE 4

| SAMPLE # | L* | a* | b* |
|---|---|---|---|
| Z-1 | 28.27 | 23.1 | 14.12 |
| Z-2 | 34.52 | 19.53 | -7.79 |
| Z-3 | 56.81 | 3.23 | 39.07 |
| Z-4 | 64.34 | 0.45 | 29.53 |
| Z-5 | 51.42 | 4.21 | 42.87 |
| BHMA605 (Brass) | 84.54 | -0.79 | 35.06 |

Table 5

| Sample Number | L* | a* | b* |
|---|---|---|---|
| T-1 | 59.3 | 6.59 | 35.36 |
| T-2 | 56.12 | 7.07 | 42.52 |
| T-3 | 57.47 | 6.25 | 45.84 |
| T-4 | 53.83 | 11.73 | 51.89 |
| T-5 | 52.9 | 8.23 | 43.77 |
| T-6 | 48.16 | 15.69 | 36.29 |
| T-7 | 58.06 | 5.33 | 42.36 |
| T-8 | 47.59 | 9.83 | 47.07 |
| T-9 | 51.78 | 9.67 | 49.78 |
| T-10 | 44.59 | 13.74 | 52.78 |
| GOLD | 89.73 | 7.22 | 36.13 |

While the colour data shows considerable variation as tested and from the objective "eye" of the photospectrometer, the surfaces of polished samples would look essentially the same to the untrained observer. For this reason it is evident that the expensive metal component of each of the zirconium and titanium-based films can be reduced by incorporation of relatively inexpensive oxygen and carbon.

Please note that the more important determinants of colour appearance are the values of a and b. The values of a and b obtained experimentally are close to the colour standards referenced above. The L values relate to the brightness and are a measure of the degree of polish of the substrate rather than a measure of the colour appearance.

The additive gas is nitrogen and/or ammonia. The gas is introduced into the reactor upstream of the substrate so as to generate a nitrogen ion and/or ammonium ion plasma. The plasma then diffuses into the gaseous precursor ions within the reactor to form the metal nitride on the substrate. Ammonia is preferred because of its lower dissociation energy requirement. Thus, where there is a constant microwave and gas flow input, there are more active nitrogen atoms in the plasma, thereby enhancing the desired metal nitride film deposition. Further, the atomic hydrogen generated in the reaction zone helps scavenge the carbon atoms from the plasma thereby greatly reducing the tendency to form discolored carbon containing nitrides.

The carrier gases are the "noble" gases. Helium is the most preferred carrier; neon the next most preferred carrier, and argon the least preferred. The heavier argon ions tend to discolor the product films because they more easily break up the carbon-to-carbon bonds and/or the carbon-to-oxygen bonds of the additives rather than the metal to ligand bonds.

The precursors used in the process are the titanium and zirconium tetra lower alkyl oxides (precursors with lower carbon being preferred), which combine relatively low boiling points with high vapor pressures. Exemplary of such compounds are titanium tetra isopropoxide, titanium tetra (2-methyl-2-butoxide) and zirconium tetra (t-butoxide). Each of the precursors has a tetrahedral structure with the metal atom in the centre bonded to the four ligands. The preferred precursor compounds are titanium tetra-isopropoxide, zirconium tetra (2-methyl-2-butoxide), titanium tetra n-propoxide, zirconium tetra n-propoxide and titanium n-butoxide.

The precise transparency/opacity colour, film depth, electrical conductance, adhesion properties and film hardness will be predetermined for a specific usage. Thus, cutting tools will have film specifications, e.g., hardness and a degree of electrical conductivity, which will not be necessary for kitchen sink hardware. Multi-layer substantially transparent films forming interlayers with $SiO_2$ films in architectural glass or ophthalmic lenses will have different specifications. Those skilled in the art will be able to determine the process details for the manufacture of each of their specific products using the graph of Fig. 2 and described reactants, reactant composition, flow rate, etc., with only routine testing in their reactor and instrumentation configurations.

The resistance, as determined with a standard multimeter, provides a quick check for the process designer and operator. Thus, a low resistance film will indicate the formation of an opaque film of desired color without the necessity for polishing. Where the resistivity is high, the film will normally be transparent. Additionally, there are generally no "middle" resistivities, i.e., the resistivities are either very low or substantially dielectric.

Those skilled in the art will be able to determine the process details for the manufacture of each of their specific products from the described reactant, reactant composition, flow rate, etc., with only routine testing in their reactor and instrumentation configurations.

**Claims**

1. A coloured, opaque, electrically conductive nitride film of a transition metal selected from the group consisting of titanium and zirconium adhered to a substrate containing at least 5 atomic percent oxygen.

2. The nitride film of Claim 1 and further containing at least about 7 atomic percent oxygen.

3. The film of claim 1 or 2 and additionally containing at least about 4 atomic percent carbon.

4. The film of Claim 1 and containing about 5 to about 35 atomic percent oxygen.

5. The film of claim 4 and containing about 15 to about 30 atomic percent oxygen.

6. A coloured film of a transparent, substantially nonconductive transition metal nitride selected from the group consisting of titanium nitride and zirconium nitride containing from about 5 to about 60 atomic percent oxygen.

7. A film according to Claim 6, wherein the nitride film contains from about 5 to about 60 atomic percent oxygen and at least 4 atomic percent carbon.

8. A nitride film according to any one of claims 1 to 5, wherein the substrate is a metal.

**9.** A nitride film according to any one of claims 1 to 5, wherein the substrate is a glass.

**10.** A nitride film according to any one of claims 1 to 5, wherein the substrate is a plastic.

**11.** A nitride film according to any one of claims 1 to 6, wherein the film is a zirconium nitride film with a brass colour.

**12.** A nitride film according to any one of claims 1 to 6, wherein the film is a titanium nitride film with a gold colour.

**13.** In a process for the production of films of nitrides of transition metals selected from the group consisting of titanium and zirconium by reacting, within a reactor, an additive gas with at least one of a titanium and zirconium tetra alkyl oxide in the presence of a noble gas carrier under vacuum; **characterised by** adjusting the gas flow rate and working pressures to maintain within the reactor the relationship described in the graph of Figure 2 and maintaining the power input and carrier gas flow at an opaque film producing level.

**14.** A process according to Claim 13, wherein the gas flow rate, working pressure, power input and carrier gas flow are maintained within a range predetermined to ensure a predetermined film resistivity, opacity and colour.

**15.** A process according to Claim 14, wherein an opaque, brass coloured film with a high electrical conductivity is formed.

**16.** A process according to Claim 14, wherein an opaque, brassy gold coloured film with a high electrical conductivity is formed.

**17.** A process according to Claim 14, wherein a transparent yellow coloured film with a high electrical conductivity is formed.

**18.** A process according to Claim 14, 15, 16 or 17, wherein the power input and carrier gas flow are maintained at an opaque film producing level.

**19.** A process for the production of films of transition metals having predetermined properties selected from the group consisting of titanium nitrides and zirconium nitrides on a substrate comprising introducing into a reactor at least one carrier gas, at least one additive gas and alkane oxide precursor of at least one of titanium and zirconium, reacting the precursor and additive gas in an electron cyclotron resonance plasma established at at least one frequency of frequencies ranging from about 0.1 GHz to about 10 GHz having an ion density of from about $10^7 cm^{-3}$ to $10^{13} cm^{-3}$ at pressures of from about $10^{-4}$ Torr to 1.0 Torr in the presence of a substantially uniform reactant gas flow around the substrate and forming a transition metal nitride utilising a predetermined gas flow and a working pressure relationship and forming transition metal nitride film electrically conductive on the substrate having at least 5 atomic percent oxygen.

**20.** A process according to Claim 19, wherein the transition metal nitride film contains at least about 7 atomic percent oxygen.

**21.** A process according to Claim 19 or 20, additionally containing at least about 4 atomic percent carbon.

**22.** A process according to Claim 19, wherein the nitride film contains from about 5 to about 60 atomic percent oxygen.

**23.** A process according to Claim 19, wherein the nitride film contains from about 15 to about 45 atomic percent oxygen.

Fig. 1

The relationship of the preferred gas flow vs. the working pressure.

Fig. 2

**European Patent Office**

## EUROPEAN SEARCH REPORT

Application Number

EP 01 30 4074

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X<br>Y | US 5 618 579 A (TESTULAT BERTRAND ET AL) 8 April 1997 (1997-04-08)<br>* column 3, line 60 - column 4, line 4 *<br><br>* column 4, line 42 - column 5, line 22 *<br>* column 6, line 40-42 *<br>---- | 1,2,4-6, 9,12<br>3,7,8, 10,11 | C23C16/30 |
| X<br><br>Y<br>A | FR 2 769 922 A (UNIV BOURGOGNE) 23 April 1999 (1999-04-23)<br>* page 2, line 25 - page 3, line 16 *<br>* page 6, line 18 - page 7, line 19 *<br>---- | 13-18<br><br>8<br>19 | |
| X | STOCK H-R ET AL: "CHARACTERIZATION OF TI(O,C,N) COATINGS RECEIVED BY PLASMA ASSISTED CVD"<br>PROCEEDINGS OF THE INTERNATIONAL CONFERENCE ON CHEMICAL VAPOR DEPOSITION, XX, XX,<br>1987, pages 1174-1189, XP002070258<br>* paragraph '0002! *<br>---- | 13-18 | |
| Y | US 6 057 031 A (BREME FRANK ET AL) 2 May 2000 (2000-05-02)<br>* figure 1 *<br>* column 3, line 24-48 *<br>* column 7, line 49-56 *<br>---- | 3,7,10 | TECHNICAL FIELDS SEARCHED (Int.Cl.7)<br><br>C23C |
| Y | EP 0 924 316 A (HARTEC GES FUR HARTSTOFFE UND) 23 June 1999 (1999-06-23)<br>* column 1, line 29-32 *<br>---- | 11 | |
| A | DE 195 06 579 A (FRAUNHOFER GES FORSCHUNG) 29 August 1996 (1996-08-29)<br>* column 2, line 10-33 *<br>* column 3, line 6-63 *<br>------ | 19-23 | |

The present search report has been drawn up for all claims

| Place of search | Date of completion of the search | Examiner |
|---|---|---|
| THE HAGUE | 22 August 2001 | Castagné, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

**ANNEX TO THE EUROPEAN SEARCH REPORT
ON EUROPEAN PATENT APPLICATION NO.** EP 01 30 4074

This annex lists the patent family members relating to the patent documents cited in the above-mentioned European search report.
The members are as contained in the European Patent Office EDP file on
The European Patent Office is in no way liable for these particulars which are merely given for the purpose of information.

22-08-2001

| Patent document cited in search report | | Publication date | Patent family member(s) | | Publication date |
|---|---|---|---|---|---|
| US 5618579 | A | 08-04-1997 | FR | 2708924 A | 17-02-1995 |
| | | | DE | 69421467 D | 09-12-1999 |
| | | | DE | 69421467 T | 11-05-2000 |
| | | | EP | 0638527 A | 15-02-1995 |
| | | | EP | 0933340 A | 04-08-1999 |
| | | | ES | 2139720 T | 16-02-2000 |
| | | | JP | 7187713 A | 25-07-1995 |
| | | | PT | 638527 T | 28-04-2000 |
| FR 2769922 | A | 23-04-1999 | NONE | | |
| US 6057031 | A | 02-05-2000 | DE | 19736449 A | 25-02-1999 |
| | | | EP | 0897997 A | 24-02-1999 |
| | | | JP | 11229146 A | 24-08-1999 |
| EP 0924316 | A | 23-06-1999 | DE | 19756588 A | 01-07-1999 |
| | | | US | 6255007 B | 03-07-2001 |
| DE 19506579 | A | 29-08-1996 | NONE | | |

EPO FORM P0459

For more details about this annex : see Official Journal of the European Patent Office, No. 12/82